# FASCICULE DE BREVET EUROPEEN

(11) **EP 2 877 273 B1**
(45) Date de publication et mention de la délivrance du brevet: **26.10.2022**
(21) Numéro de dépôt: 13747467.2
(22) Date de dépôt: 19.07.2013
(51) Int. Cl.: B01D 67/00, H01J 37/244, H01J 37/305, B01D 71/02, B01D 61/02

(54) **PROCEDE ET INSTALLATION DE FORMATION DE MEMBRANE NANO-POREUSE**
VERFAHREN UND VORRICHTUNG ZUR HERSTELLUNG EINER NANOPORÖSEN MEMBRAN
METHOD AND APPARATUS FOR FORMING A NANOPOROUS MEMBRANE

(30) Priorité: 25.07.2012 FR 1257206
(43) Date de publication de la demande: 03.06.2015
(73) Titulaire: Centre National de la Recherche Scientifique (C.N.R.S.), 75794 Paris Cedex 16 (FR)
(72) Inventeur: GIERAK, Jacques, 91220 Le Plessis Pate (FR)
(74) Mandataire: Lavoix
(86) Numéro de dépôt international: PCT/FR2013/051752
(87) Numéro de publication internationale: WO 2014/016505

(56) Documents cités:
- WARREN J MOBERLYCHAN: "Dual-beam focused ion beam/electron microscopy processing and metrology of redeposition during ion-surface 3D interactions, from micromachining to self-organized picostructures", JOURNAL OF PHYSICS: CONDENSED MATTER, INSTITUTE OF PHYSICS PUBLISHING, BRISTOL, GB, vol. 21, no. 22, 3 juin 2009 (2009-06-03), page 224013, XP020160096, ISSN: 0953-8984
- JIALI LI ET AL: "Ion-beam sculpting at nanometre length scales", NATURE: INTERNATIONAL WEEKLY JOURNAL OF SCIENCE (AND SUPPLEMENTARY INFORMATION), NATURE PUBLISHING GROUP, UNITED KINGDOM, vol. 412, no. 6843, 12 juillet 2001 (2001-07-12), pages 166-169, XP007911230, ISSN: 0028-0836, DOI: 10.1038/35084037
- ERLEBACHER J ET AL: "Spontaneous pattern formation on ion bombarded Si(001)", PHYSICAL REVIEW LETTERS, AMERICAN PHYSICAL SOCIETY, US, vol. 82, no. 11, 15 mars 1999 (1999-03-15) , pages 2330-2333, XP002254893, ISSN: 0031-9007, DOI: 10.1103/PHYSREVLETT.82.2330
- FERTIG N ET AL: "Microstructured glass chip for ion-channel electrophysiology", PHYSICAL REVIEW E. STATISTICAL PHYSICS, PLASMAS, FLUIDS, AND RELATED INTERDISCIPLINARY TOPICS, AMERICAN INSTITUTE OF PHYSICS, NEW YORK, NY, US, vol. 64, no. 4 I, 1 octobre 2001 (2001-10-01), pages 409011-409014, XP002381286, ISSN: 1063-651X

## Description

La présente invention est relative aux procédés et aux installations de formation de membranes nano-poreuses.

Plus particulièrement, l'invention se rapporte à un procédé de formation d'une membrane nano-poreuse comprenant :
- on fournit un générateur de faisceau d'ions utilisant une source d'ions de métal liquide, la source étant adaptée pour émettre un faisceau d'espèces chargées selon un axe optique,
- on fournit un porte-échantillon portant une membrane en regard de la source le long de l'axe optique.

Le document B. Schiedt et al. intitulé « Direct FIB fabrication and intégration of 'single nanopore devices' for the manipulation of macromolecules », Microelectron. Eng. (2010), doi : 10.1016/j.mee.2009.12.073 décrit un exemple d'un procédé au cours duquel on grave un nanopore dans une membrane à l'aide d'une machine FIB (« focused ion beam » pour « faisceau d'ions focalisé »). De telles membranes, présentant un pore de diamètre de l'ordre de 100 nanomètres ou moins, ont d'innombrables applications, notamment en biologie, par exemple pour être utilisées pour des procédés d'électrophorèse.

De tels procédés de gravure sont également décrits dans les documents Patterson N et al. : « Controlled fabrication of nanopores using a direct focused ion beam approach with back face particle détection », Nanotechnology, Iop, Bristol, GB, voL .19, no. 23, 11/06/08, page 235304, et Nagoshi Kotaro et al. : « Direct fabrication of nanopores in a metal foil using focused ion beam with in situ measurements of the penetrating ion current », Review of scientific instruments, AIP, Melville , NY, US, vol. 80, no. 12, 07/12/09, pages 125102.

Par ailleurs, Jiali Li et al., « Ion beam sculpting at nanometre length scales », Nature 412, 166-169 (12/07/01) | doi :10.1038/35084037, décrit un procédé de bouchage d'un pore obtenu au préalable dans une autre installation.

La fabrication simple, économique, reproductible, de pores présentant de manière contrôlée des caractéristiques variables (notamment taille et matériau du substrat variables) constitue aujourd'hui un défi, pour s'adapter à une demande toujours croissante de membranes nano-poreuses.

Par exemple, Warren J Moberlychan : « Dual-beam focused ion beam/electron microscopy processing and metrology of redeposition during ion-surface 3D interactions, from micromachining to self-organized picostructures", Journal of physics: Condensed matter, Institute of Physics Publishing, Bristol, GB, vol. 21, no. 22, 03/06/09, page 224013, décrit un procédé de bouchage d'un pore semblant utiliser un mécanisme d'érosion. Toutefois, un tel mécanisme d'érosion présente une faible reproductibilité, et est assez intrusif pour la membrane, avec des risques importants de détérioration mécanique et/ou de contamination chimique par l'espèce en provenance de la source.

La présente invention a notamment pour but de fournir une telle fabrication.

A cet effet, selon l'invention, un procédé du genre en question est défini dans la revendication 1.

Grâce à ces dispositions, on obtient un pore dont on peut contrôler les propriétés.

Dans des modes de réalisation préférés de l'invention, on peut éventuellement avoir recours en outre à l'une et/ou à l'autre des dispositions suivantes :
- on fournit le détecteur de particules chargées en aval de la membrane le long de l'axe optique, le détecteur de particules étant adapté pour détecter un nombre d'ions transmis à travers la membrane ;
- on focalise le faisceau d'ions au niveau du porte-échantillon en une zone de diamètre réglable, le diamètre étant réglable au moins entre 10 et 100 nanomètres ;
- on met en œuvre le mode de perçage au cours duquel le générateur émet un faisceau d'ions de formation d'un pore dans la membrane, et on détecte un nombre d'ions transmis à travers le pore,
   on met en œuvre le mode de rebouchage au cours duquel le générateur émet un faisceau d'ions de rebouchage d'un pore ;
- lorsqu'on contrôle le générateur de faisceau d'ions, on contrôle un trajet dudit faisceau ;
- dans le mode de perçage, tant qu'on détecte un nombre d'ions inférieur à un seuil prédéterminé, le générateur délivre un faisceau d'espèces chargées sur une zone de la membrane [Dans ce mode perçage, la zone est assimilée à un point fixe de dimensions faibles - de l'ordre de 10 nanomètres par exemple ; Le courant d'ions I est concentré sur une surface de superficie Sₚ de sorte que le rapport I/S est suffisamment élevé pour produire un effet de gravure intense (I/Sₚ par exemple de l'ordre de 10¹⁸ ions/cm²)];
- lorsqu'on détecte un nombre d'ions supérieur à un seuil prédéterminé, on divertit le faisceau d'espèces chargées en dehors du porte-échantillon ;
- dans le mode de rebouchage, tant qu'on détecte un nombre d'ions supérieur à un seuil prédéterminé, le générateur délivre un faisceau d'espèces chargées sur une zone élargie autour du pore;
- dans le mode de rebouchage, on rebouche le pore par irradiation de la membrane autour du pore avec ledit faisceau [Dans ce mode rebouchage, la zone irradiée est de dimensions élevées ; Un balayage du faisceau permet d'augmenter la superficie de la surface Sᵣ de la zone de la membrane irradiée par le faisceau autour du pore de plusieurs ordres de grandeur par rapport au mode perçage, de sorte que le rapport I/Sᵣ soit réduit à une valeur très faible par rapport à I/Sₚ (I/Sᵣ par exemple de l'ordre de 10¹² ions/cm²)] ;
- dans le mode de rebouchage, on rebouche le pore en balayant une zone de superficie étendue de la membrane autour du pore avec ledit faisceau ;
- lorsqu'on contrôle le générateur de faisceau d'ions, on contrôle une zone d'impact du faisceau sur la membrane ;
- la membrane a une épaisseur inférieure à 10 nanomètres, et/ou est réalisée en un matériau choisi dans la liste suivante : carbure de silicium, oxyde de silicium, nitride de silicium ;
- on contrôle le générateur de faisceau d'ions en commandant l'ouverture et la fermeture d'une porte électrostatique disposée entre la source et le porte-échantillon ;
- on définit un diamètre de pore à atteindre, et on alterne les modes de perçage et de rebouchage jusqu'à former un pore dudit diamètre ;
- on reproduit lesdites étapes pour une pluralité de membranes d'un même échantillon, les membranes étant espacées les unes des autres d'au moins 10 microns, ou pour une pluralité de pores dans une membrane d'un échantillon, les pores étant espacés les uns des autres d'au moins 0.1 micron.

Selon un autre aspect, l'invention se rapporte à une installation de formation d'une membrane nanoporeuse selon la revendication 16.

Selon un mode particulier, le générateur de faisceau d'ions comprend une optique électrostatique comprenant également :
- un générateur de balayage adapté pour disperser le faisceau autour d'un pore de la membrane ; et/ou
- un générateur d'effacement adapté pour divertir le faisceau hors du porte-échantillon, et/ou
- une lentille focalisant le faisceau d'ions au niveau du porte-échantillon en une zone de diamètre réglable, le diamètre étant réglable au moins entre 10 et 100 nanomètres.

D'autres caractéristiques et avantages de l'invention apparaîtront au cours de la description suivante de deux de ses formes de réalisation, donnée à titre d'exemple non limitatif, en regard des dessins joints.

Sur les dessins :
- la figure 1 est une vue schématique d'une installation convenant pour la mise en œuvre du procédé,
- les figures 2a, 2b et 2c sont des vues schématiques de la membrane à différentes étapes dans une première utilisation de l'installation de la figure 1,
- les figures 3a, 3b sont des vues similaires aux figures 2a à 2c, pour un deuxième mode d'utilisation de cette installation,
- la figure 4 est une vue schématique d'un échantillon à différentes étapes,
- les figures 5a et 5b sont des vues de dessus d'une membrane comportant plusieurs pores (respectivement vue microscopique et schéma illustratif),
- les figures 6a et 6b sont deux vues similaires à la figure 1 de deux modes d'utilisation de l'installation, et
- la figure 7 montre un système multi-membranes.

Sur les différentes figures, les mêmes références désignent des éléments identiques ou similaires.

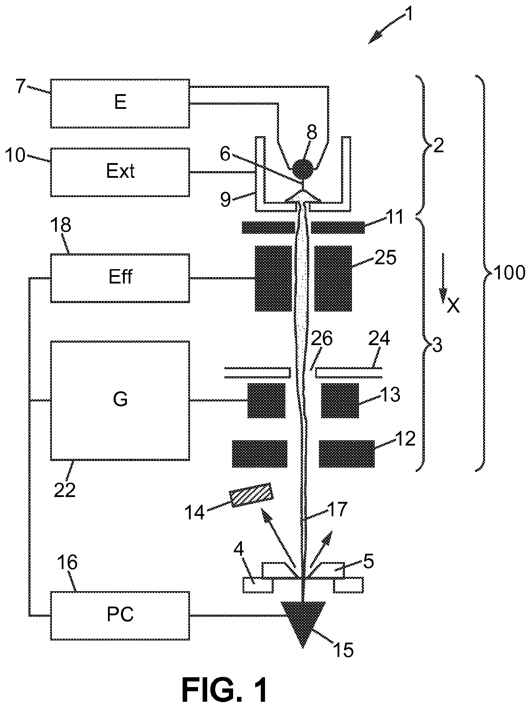

La figure 1 représente une installation 1 convenant pour la mise en œuvre d'un procédé de traitement de membrane nanoporeuse. Une architecture d'une telle installation reprend celle d'une colonne d'émission de faisceau d'ions focalisés (FIB, pour « focussed ion beam»). Elle comporte en particulier un générateur 100 de faisceau d'ions muni d'une source 2 et d'une optique 3. L'installation comprend également un porte échantillon 4 portant un échantillon 5. La source, l'optique et le porte échantillon sont disposés l'un après l'autre, selon cet ordre, le long d'un axe X du générateur.

La source est une source d'ions de métal liquide (LMIS, pour « liquid metal ion source »). Elle comporte une pointe 6 reliée électriquement à un générateur 7. Le générateur fournit à la pointe 6 une tension permettant de polariser la pointe. La pointe est réalisée comportant un noyau, par exemple d'un métal réfractaire, portant une couche continue de métal à sa surface. Le métal, par exemple du gallium, ou un alliage d'or, ou autre, est par exemple également contenu dans un réservoir 8 à partir duquel il s'écoule vers l'extrémité de la pointe. La source d'ions 2 comprend également une électrode extractrice 9 qui peut être alimentée par un générateur dédié 10, afin de générer une différence de potentiel entre une électrode extractrice 9 et la pointe 6. Cette différence de potentiel génère un champ électrique qui est apte à arracher des ions de métal liquide, ou des amas de ces ions de la pointe 6. Les ions ainsi arrachés sont propagés en un faisceau 17 globalement en direction du porte échantillon 4 le long de l'axe X.

L'optique 3 comprend une série de lentilles adaptées pour mettre en forme le faisceau d'ions. On notera en particulier une lentille 11, proche de la source 2, adaptée pour mettre en forme le faisceau d'ions, et une lentille objet 12 proche du porte-échantillon 4, adaptée pour concentrer le faisceau d'ions en direction du porte-échantillon 4.

Entre les lentilles 11 et 12, on prévoit un dispositif de balayage 13 pour étaler le faisceau d'ions sur une zone donnée du porte-échantillon 4. Ce générateur de balayage 22 comprend une ou plusieurs électrodes 13 adaptées pour influencer électriquement sur les particules chargées passant à proximité, pour dévier leur trajectoire, de manière changeant dans le temps, en direction de points donnés du porte-échantillon 4. Lorsqu'il est activé, le dispositif de balayage 13 permet d'étaler le faisceau sur une zone de la membrane, de superficie grande par rapport au diamètre du pore, par exemple de l'ordre de 100 nm x 100 nm.

L'installation comprend également un système d'effacement de faisceau comprenant une série de déflecteurs électrostatiques 25, par exemple situées proche de la source 2, et une électrode d'arrêt 24, située en aval des lentilles 25, et comportant une ouverture traversante 26 de faible diamètre. Un tel système d'effacement constitue une porte électrostatique pour le faisceau, dont on peut contrôler à volonté les états « ouvert » ou « fermé ». Le générateur 18 d'effacement peut alimenter les électrodes 25 de manière à faire passer le faisceau 17 au travers de l'ouverture 26 (tel que représenté), ou de diriger celui-ci vers l'électrode d'arrêt 24.

Le générateur 18 est par exemple un générateur de tension bistable rapide, permettant un temps de montée ou de descente inférieur à la micro-seconde.

Dans le cas présent, le porte-échantillon 4 porte une membrane 5 à former. La membrane 5 est par exemple constituée d'un mince film de matériau résistant mécaniquement, tels qu'un carbure, oxyde ou nitrure de silicium, ou autre. Il s'agit par exemple d'un film non cristallin. Un exemple de matériau constitutif est Si₃N₄. La membrane 5 fait 100 nm d'épaisseur, en particulier moins de 25 nm d'épaisseur, voire moins de 10 nm d'épaisseur.

On peut utiliser également un détecteur 14 de particules secondaires. Ces particules secondaires sont des particules, notamment chargées, pulvérisées de la membrane 5 à l'arrivée du faisceau d'ions en provenance de la source 2.

On utilise un détecteur 15 situé en aval du porte échantillon 4 le long de l'axe X. Ainsi, le porte échantillon 4 est disposé entre la source 2 et le détecteur 15. À titre de détecteur 15, on utilise un détecteur de particules, adapté pour détecter des particules, notamment chargées électriquement, s'écoulant depuis la source : les ions ou amas chargés provenant de la source 2. À titre de détecteur de particules, on utilise un détecteur capable de détecter les faibles niveaux de signal attendu avec de telles sources d'ions. Il s'agit, par exemple, d'un détecteur de type channeltron, ou plaques multicanaux.

L'installation 1 comprend également une unité centrale 16 reliée au détecteur 15. L'unité centrale 16 est capable de déterminer le nombre de particules détectées par le détecteur 15.

En variante, on pourrait utiliser un détecteur 15 de particules secondaires disposé hors de l'axe optique, et placé en regard de la face supérieure (celle tournée vers la source 2) d'une cible placée en aval du porte-échantillon 4, et détectant des électrons, dits secondaires, projetés depuis la cible du fait de l'arrivée sur celle-ci des particules chargées en provenance de la source 2. Le nombre de particules chargées traversant la membrane peut être déterminé, indirectement, à partir du signal mesuré par le détecteur d'électrons secondaires. La suite de la description fait référence au mode de réalisation utilisant le détecteur aval 15 de type direct disposé le long de l'axe optique.

L'unité centrale 16 est également capable de commander l'arrivée du faisceau 17 au niveau du porte échantillon 4. À titre d'exemple, l'unité centrale 16 est reliée au générateur de balayage 13. Ainsi, l'unité centrale 16 est capable de comparer le nombre de particules détectées par le détecteur 15 avec un niveau de seuil prédéterminé, et, en fonction de cette comparaison, d'influer sur l'arrivée du faisceau 17 au niveau du porte échantillon 4.

Deux exemples de mise en œuvre d'une telle installation vont être décrits ci-après, les deux exemples faisant correspondance aux deux modes des revendications indépendantes 1 et 16.

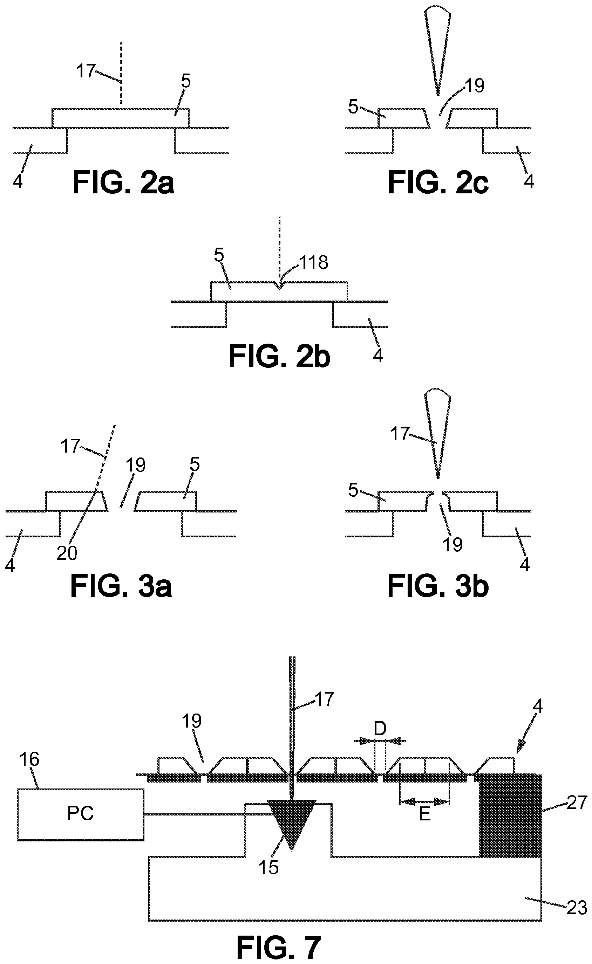

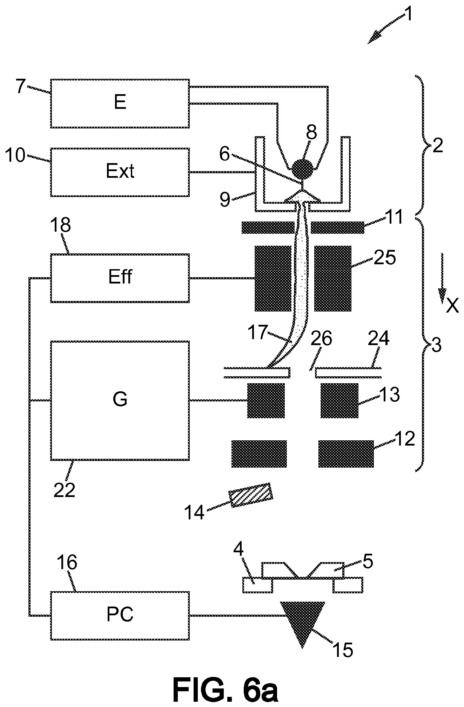

Dans un premier exemple, le premier mode, représenté aux figures 2a à 2c, le porte échantillon 4 porte une membrane 5 étanche. Ainsi, la membrane 5 ne comporte aucun pore, et il s'agit donc ici d'un procédé de formation d'une membrane. Comme cela est visible sur les figures 1 et 2a, le faisceau 17 d'ions de métal liquide impacte en un emplacement donné de la membrane 5 de manière à enlever de la matière, comme représenté sur la figure 2b. Le faisceau d'ions métalliques, ayant une énergie de l'ordre de la dizaine de milliers d'électrons-Volts, focalisé au niveau de la membrane mince sur un point fixe (mode « point ») va produire un effet de gravure localisé dans la membrane. La dose d'ions incidente se déduit en mesurant le courant I déposé par les ions (au cours d'une étape préalable de calibration avec un micro-Ampèremètre à la place du porte-échantillon), en multipliant par la durée t de l'irradiation et en divisant le tout par la surface S du point irradié : D=It/S. A titre d'exemple, une dose courante pour ce mode perçage est de l'ordre de 10¹⁸ à 10²⁰ ions/cm². Par point, on entend une tache focale de diamètre le plus petit possible atteignable au niveau du porte-échantillon. Les dimensions d'une tâche focale(en mode « point ») sont par exemple de l'ordre de 10 nanomètres. Ainsi, au cours de l'utilisation de la source 2, une ouverture 118 commence à apparaître dans la membrane 5. Au cours de cette opération, le détecteur 15 est relié à l'unité centrale 16. Au niveau de l'unité centrale, on compare le signal reçu du détecteur 15 avec un seuil prédéterminé. Étant donné que la membrane 5 est étanche, le détecteur 15 ne détecte rien d'autre qu'un bruit, au cours de cette étape. Ainsi, le niveau de signal détecté par le détecteur 15 est inférieur au seuil prédéterminé. L'unité centrale 16 est commandée de manière à ce que, lorsque le signal détecté par le détecteur 15 dépasse ledit seuil prédéterminé, le générateur d'effacement 18 divertit le faisceau 17 de l'endroit où le pore est réalisé, par exemple vers l'électrode d'arrêt 24 (figure 6a). Ainsi, comme visible sur la figure 2c, au bout d'un certain temps d'utilisation de la source d'ions 2, un pore 19 a été créé dans la membrane 5. L'utilisation ultérieure de la source 2 voit les ions métalliques passer à travers le pore 5, et un nombre d'ions, voire un courant électrique être ainsi détecté par le détecteur 15. Tous les ions métalliques ne passent pas à travers le pore 5, et l'ouverture de celui-ci va augmenter au cours de l'utilisation de la source d'ions, ainsi que le courant détecté. Quand ce courant atteint un seuil prédéterminé, l'unité centrale 16 fait divertir le faisceau hors du porte échantillon 4.

Le seuil correspond par exemple à la détection d'un unique ion du faisceau 17 au niveau du détecteur 15. Le temps de gravure peut alors typiquement être de l'ordre de 50 à 100 millisecondes (ms).

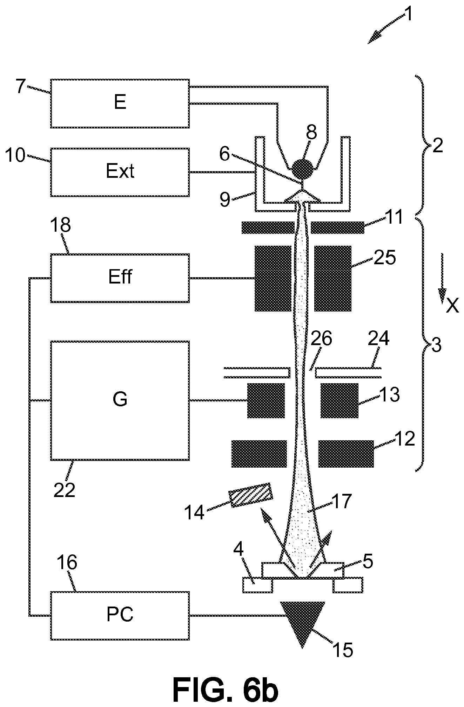

Selon le deuxième mode, comme représenté sur les figures 3a à 3b, on peut utiliser l'installation de la figure 1 pour former un pore 19 existant. Ainsi, on fournit sur le porte échantillon 4 une membrane 5 déjà dotée d'un pore 19. Le cas échéant, on utilise le détecteur 15 pour détecter les ions traversant le pore 19, et caractériser ainsi ce pore. Comme visible sur la figure 6b, pour reboucher légèrement le pore 19, le faisceau 17 irradie une zone élargie, par exemple de dimensions 100 nm x 100 nm autour du pore, comprenant des emplacements 20 de la surface de la membrane 5 à proximité du pore 19, à l'aide du générateur de balayage 13. C'est-à-dire qu'on utilise la même source que dans le mode de perçage décrit ci-dessus, l'utilisation différanciant principalement en ce qu'on change rapidement les caractéristiques du générateur de balayage 30 pour que le point d'impact des particules chargées successives arrivant au niveau du porte-échantillon décrive une trajectoire dans une zone élargie. Dans ce mode 'surface', la dose peut être réduite à des valeurs inférieures au mode 'point', par exemple de l'ordre de 10¹² ions/cm², ce qui est insuffisant pour provoquer un enlèvement de matière significatif (a fortiori pour créer un autre pore). Comme visible sur la figure 3b, on observe dans la zone visée par le faisceau 17 une diffusion des atomes de la membrane 5 faiblement liés à sa surface, et une agrégation d'atomes au niveau des arêtes vives de la membrane, comme également indiqué dans Jiali Li et al., « Ion beam sculpting at nanometre length scales », Nature 412, 166-169 (12/07/01) | doi :10.1038/35084037. C'est-à-dire que la membrane comporte une surface tournée vers la source. En cette surface (ou à faible profondeur à l'échelle de l'épaisseur de la membrane), l'irradiation par les particules chargées en provenance de la source va créer une diffusion d'atomes de la membrane en direction des arêtes proches, c'est-à-dire les arêtes délimitant le pore. La matière va s'y agréger, fermant ainsi le pore. Le pore va ainsi être réduit par irradiation, par le faisceau, d'emplacements à la proximité du pore. Comme on peut encore le voir sur la figure 3b, l'ouverture du pore peut continuer d'être testée en utilisant le faisceau 17 et en détectant les particules transmises à travers le pore à l'aide du détecteur 15. En effet, la trajectoire mentionnée ci-dessus peut croiser le pore.

En utilisant le procédé ci-dessus pour le bouchage du pore, on respecte la membrane, en générant peu de vibrations mécaniques dans la membrane, en implantant peu de matériaux contaminants (Gallium) dans la membrane. En utilisant une membrane en matériau non cristallin, on génère également peu de dégâts dans la membrane.

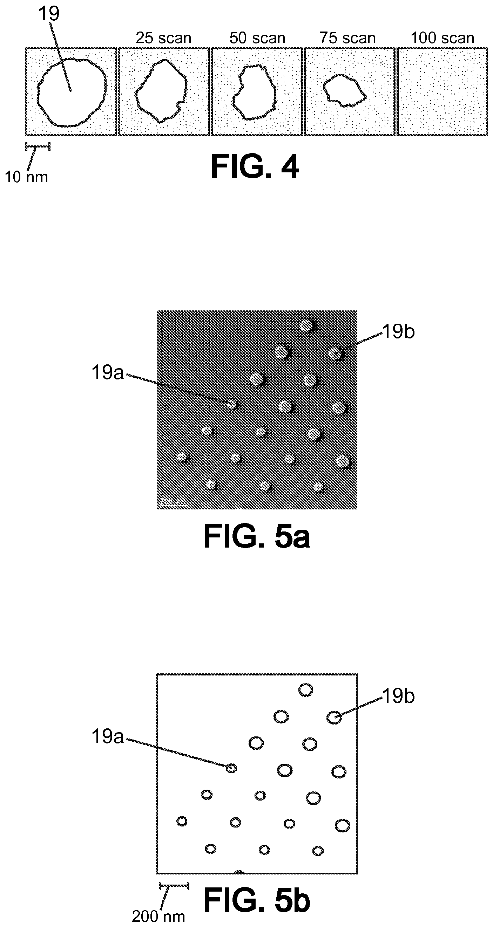

Ainsi, la figure 4 représente cinq images successives de rebouchage d'un pore en utilisant l'objet ci-dessus. Après avoir percé un pore d'environ 20 nm de diamètre, comme représenté sur la première vignette, les quatre autres vignettes représentent le rebouchage successif de celui-ci par irradiation de zones à proximité de celui-ci, jusqu'à un rebouchage complet sur la vignette de droite.

L'optique 3 peut également être utilisée pour modifier l'énergie des ions à leur arrivée au niveau du porte-échantillon. Ainsi, en mode pulvérisation (creuser un pore), on peut utiliser des ions de plus haute énergie. En mode de rebouchage et d'imagerie, on peut utiliser des ions d'énergie plus faible, le détecteur détectant la charge des ions traversant. Ainsi, les ions utilisés en mode d'imagerie, s'ils ne traversent pas, risquent moins d'affecter la membrane.

Si le matériau du faisceau d'ions est indésirable dans la membrane, on pourra prévoir de l'enlever par une attaque chimique adaptée.

De plus, on met en œuvre successivement le procédé de création d'un pore, tels que décrit ci-dessus en relation avec les figures 2a à 2c, et un procédé de rebouchage tel que décrit ci-dessus avec les figures 3a et 3b, de manière à pouvoir générer un pore de taille parfaitement souhaitée. Cette mise en œuvre successive est faite en utilisant la même installation, la même source, pour les deux procédés. Ainsi, la source reste invariable, que ce soit en mode de perçage, de rebouchage, ou pour la détection du courant transmis. La source émet un courant I sensiblement constant, et des articules d'énergie sensiblement constante dans ces différents modes. Le courant I et l'énergie des particules arrivant au niveau de la membrane sont également gardés constant dans ces différentes modes. En mode rebouchage, on peut générer l'émission du faisceau 17 pendant un temps prédéterminé, basé sur l'expérience, pour obtenir un certain rebouchage du pore. Alternativement, après un temps donné, on peut procéder à la détection du signal transmis à travers le pore à l'aide du détecteur 15, et vérifier son éventuel rebouchage, et, si nécessaire, procéder à une nouvelle opération de rebouchage. On obtient donc un pore dont on peut contrôler les propriétés (taille (diamètre, ou diamètre moyen), rapport d'aspect), la position par rapport à des électrodes (de mesure ou de contrôle), et l'environnement (chimique, physiologique). Concernant la taille, on considérera le plus petit diamètre transversalement à l'axe du pore (axe normal à la surface de la membrane).

La description qui a été faite ci-dessus a été faite pour un pore. Toutefois, on pourra, avec le même outil, aisément réaliser la même opération successivement pour plusieurs pores, comme représenté en figures 5a et 5b, espacés les uns des autres d'au moins 100 nanomètres. On pourra d'ailleurs réaliser sur un même support des pores de taille variable, de diamètre petit, tels les pores 19a, ou de diamètre élevé, tels les pores 19b, ceci étant ajustable à volonté. Les pores peuvent être réalisés comme des réseaux ordonnés dans la membrane. La membrane présentant plusieurs pores peut être utilisée telle quelle, ou être découpée en vue de plusieurs applications ou utilisations parallèles distinctes. Comme représenté Figure 7, dans un mode de réalisation, le détecteur 15 est monté mobile dans l'enceinte par l'intermédiaire d'un système de déplacement nanométrique 23. Ce système 23 lui-même porte un système de déplacement micrométrique 27 portant l'échantillon 4. L'échantillon 4 est formé comme une tranche épaisse comprenant plusieurs membranes indépendantes de dimension D de quelques microns, et dans chacune desquelles un pore est à former, et espacées les unes des autres de quelques centaines de microns (dimension E d'au moins 10 microns). Le système 27 de déplacement micrométrique est adapté pour placer différentes membranes de l'échantillon 4 successivement sous le faisceau. Le cas échéant, un système de détection tel le système 14 peut être utilisé pour vérifier la position exacte de la membrane par rapport au faisceau, et l'optique 3 peut être contrôlée pour déplacer le point focal afin d'être sur que le faisceau soit focalisé sur la membrane.

Un tel système comprenant un système de déplacement nanométrique d'un détecteur, et supportant un système de déplacement micrométrique 27 peut être intégré dans une machine d'émission de faisceau d'ions focalisés classique, et pourrait être commercialisé indépendamment du reste du système. Il suffit alors de connecter le détecteur 15 au PC 16 pour mettre en œuvre les procédés ci-dessus, de manière contrôlée et répétée, pour de grands nombres de membranes d'un même échantillon.

## Revendications

1. Procédé de formation d'une membrane nano-poreuse comprenant :
- on fournit un générateur (100) de faisceau d'ions utilisant une source (2) d'ions de métal liquide, la source étant adaptée pour émettre un faisceau (17) d'espèces chargées selon un axe optique (X),
- on fournit un porte-échantillon (4) portant une membrane (5) en regard de la source le long de l'axe optique,
- on fournit un détecteur de particules chargées (15) en aval de la membrane, le détecteur de particules étant adapté pour déterminer un nombre d'ions transmis à travers la membrane,
- on contrôle le générateur (100) de faisceau d'ions en fonction dudit nombre d'ions :dans un mode de perçage, on contrôle le générateur (100)de faisceau d'ions en fonction dudit nombre d'ions pour graver un pore dans la membrane et
- dans un mode de rebouchage, on contrôle le générateur (100) de faisceau d'ions en fonction dudit nombre d'ions pour reboucher un pore de la membrane, en visant une zone avec le faisceau de sorte à faire diffuser les atomes de la membrane faiblement liés à sa surface et créer une agrégation d'atomes au niveau des arêtes vives de la membrane,
le courant et l'énergie des particules arrivant au niveau de la membrane étant gardés constants dans ces différents modes,
la membrane (4) ayant une épaisseur inférieure à 100 nanomètres.

2. Procédé selon la revendication 1, dans lequel on fournit le détecteur de particules chargées (15) en aval de la membrane le long de l'axe optique, le détecteur de particules étant adapté pour détecter un nombre d'ions transmis à travers la membrane.

3. Procédé selon l'une des revendications 1 à 2 dans lequel, lorsqu'on contrôle le générateur de faisceau d'ions, on contrôle un trajet dudit faisceau.

4. Procédé selon la revendication 3, dans lequel, dans le mode de perçage, tant qu'on détecte un nombre d'ions inférieur à un seuil prédéterminé, le générateur (100) délivre un faisceau d'espèces chargées sur une zone de la membrane.

5. Procédé selon la revendication 3 ou 4, dans lequel, lorsqu'on détecte un nombre d'ions supérieur à un seuil prédéterminé, on divertit le faisceau d'espèces chargées en dehors du porte-échantillon.

6. Procédé selon la revendication 3, dans lequel, dans le mode de rebouchage, tant qu'on détecte un nombre d'ions supérieur à un seuil prédéterminé, le générateur (100) délivre un faisceau d'espèces chargées sur une zone élargie autour du pore.

7. Procédé selon l'une des revendications précédentes, dans lequel, dans le mode de rebouchage, on rebouche le pore (19) par irradiation de la membrane autour du pore avec ledit faisceau.

8. Procédé selon l'une des revendications précédentes, dans lequel, dans le mode de rebouchage, on rebouche le pore (19) en balayant une zone de superficie étendue de la membrane autour du pore avec ledit faisceau.

9. Procédé selon l'une des revendications 1 à 8 dans lequel, lorsqu'on contrôle le générateur de faisceau d'ions, on contrôle une zone (20) d'impact du faisceau sur la membrane.

10. Procédé selon l'une des revendications 1 à 9, dans lequel la membrane (4) a une épaisseur inférieure à 10 nanomètres.

11. Procédé selon l'une des revendications 1 à 10, dans lequel la membrane (4) est réalisée en un matériau choisi dans la liste suivante : carbure de silicium, oxyde de silicium, nitrure de silicium.

12. Procédé selon l'une des revendications 1 à 11, dans lequel on contrôle le générateur de faisceau d'ions en commandant l'ouverture et la fermeture d'une porte électrostatique disposée entre la source et le porte-échantillon.

13. Procédé de formation d'une membrane nano-poreuse selon l'une des revendications précédentes, dans lequel on définit un diamètre de pore (19) à atteindre, et dans lequel on alterne les modes de perçage et de rebouchage, jusqu'à former un pore dudit diamètre.

14. Procédé de formation de membranes nano-poreuses, dans lequel on reproduit les étapes des procédés selon l'une quelconque des revendications 1 à 13 pour une pluralité de membranes d'un même échantillon, les membranes étant espacées les unes des autres d'au moins dix microns, ou pour une pluralité de pores dans une membrane d'un échantillon, les pores étant espacés les uns des autres d'au moins 0.1 micron.

15. Procédé selon l'une quelconque des revendications précédentes, dans lequel on focalise le faisceau d'ions au niveau du porte-échantillon en une zone de diamètre réglable, le diamètre étant réglable au moins entre 10 nanomètres (nm) et 100 nm.

16. Installation de formation d'une membrane nano-poreuse comprenant :
- un générateur (100) de faisceau d'ions utilisant une source (2) d'ions de métal liquide, la source étant adaptée pour émettre un faisceau (17) d'espèces chargées selon un axe optique,
- un porte-échantillon (4) adapté pour porter une membrane en regard de la source le long de l'axe optique,
- un détecteur de particules chargées (15) en aval de la membrane, le détecteur de particules étant adapté pour déterminer un nombre d'ions transmis à travers la membrane, et
- une unité centrale (16) adaptée pour contrôler le générateur de faisceau d'ions en fonction dudit nombre d'ions, en visant une zone avec le faisceau
dans laquelle l'unité centrale (16) est adaptée pour sélectionner
. un mode de perçage, au cours duquel on contrôle le générateur (100) de faisceau d'ions en fonction dudit nombre d'ions pour graver un pore dans la membrane, et
. un mode de rebouchage, au cours duquel on contrôle le générateur (100) de faisceau d'ions en fonction dudit nombre d'ions pour contrôler le générateur de faisceau d'ions en visant une zone avec le faisceau de sorte à faire diffuser les atomes de la membrane faiblement liés à sa surface et créer une agrégation d'atomes au niveau des arêtes vives de la membrane,
le courant et l'énergie des particules arrivant au niveau de la membrane étant gardés constants dans ces différents modes,
la membrane ayant une épaisseur inférieure à 100 nanomètres.

17. Installation selon la revendication 16 dans laquelle le générateur (100) de faisceau d'ions comprend une optique électrostatique (3) comprenant au moins l'un de :
- un générateur de balayage (22) adapté pour disperser le faisceau autour d'un pore de la membrane,
- un générateur d'effacement (18) adapté pour divertir le faisceau hors du porte-échantillon,
- une lentille (11, 12) focalisant le faisceau d'ions au niveau du porte-échantillon en une zone de diamètre réglable, le diamètre étant réglable au moins entre 10 nanomètres (nm) et 100 nm.

## Patentansprüche

1. Verfahren zum Bilden einer nanoporösen Membran, umfassend:
- Bereitstellen eines Generators (100) eines lonenstrahls unter Verwendung einer Quelle (2) von Flüssigmetallionen, wobei die Quelle angepasst ist, um einen Strahl (17) geladener Spezies entlang einer optischen Achse (X) zu emittieren,
- Bereitstellen eines Probenhalters (4), der eine Membran (5) gegenüber der Quelle entlang der optischen Achse trägt,
- Bereitstellen eines Detektors (15) für geladene Teilchen stromabwärts von der Membran, wobei der Teilchendetektor angepasst ist, um eine Anzahl von Ionen zu bestimmen, die durch die Membran übertragen werden,
- Steuern des Generators (100) eines lonenstrahls abhängig von der lonenzahl: in einem Durchdringungsmodus, Steuern des Generators (100) eines lonenstrahls abhängig von der lonenzahl, um eine Pore in die Membran einzuprägen, und
- in einem Verschlussmodus, Steuern des Generators (100) eines lonenstrahls abhängig von der lonenzahl, um eine Pore der Membran zu verschließen, wobei mit dem Strahl auf einen Bereich gezielt wird, sodass die Atome der Membran, die schwach an ihre Oberfläche gebunden sind, diffundieren und an den scharfen Kanten der Membran eine Anhäufung von Atomen erzeugen,
wobei der Strom und die Energie der an der Membran ankommenden Teilchen in diesen verschiedenen Modi konstant gehalten werden,
wobei die Membran (4) eine Stärke von weniger als 100 Nanometern aufweist.

2. Verfahren nach Anspruch 1, wobei der Detektor für geladene Teilchen (15) stromabwärts von der Membran entlang der optischen Achse bereitgestellt wird, wobei der Teilchendetektor angepasst ist, um eine Anzahl von Ionen zu erfassen, die durch die Membran übertragen werden.

3. Verfahren nach einem der Ansprüche 1 bis 2, wobei beim Steuern des Generators eines lonenstrahls ein Verlauf des Strahls gesteuert wird.

4. Verfahren nach Anspruch 3, wobei in dem Durchdringungsmodus der Generator (100) einen Strahl geladener Spezies auf einen Bereich der Membran abgibt, solange eine lonenzahl unterhalb eines vorbestimmten Schwellenwerts erfasst wird.

5. Verfahren nach Anspruch 3 oder 4, wobei, wenn eine lonenzahl oberhalb eines vorbestimmten Schwellenwerts detektiert wird, der Strahl der geladenen Spezies aus dem Probenhalter abgelenkt wird.

6. Verfahren nach Anspruch 3, wobei in dem Verschlussmodus der Generator (100) einen Strahl geladener Spezies auf einen erweiterten Bereich um die Pore herum abgibt, solange eine lonenzahl oberhalb eines vorbestimmten Schwellenwerts erfasst wird.

7. Verfahren nach einem der vorherigen Ansprüche, wobei in dem Verschlussmodus die Pore (19) durch Bestrahlen der Membran um die Pore herum mit dem Strahl verschlossen wird.

8. Verfahren nach einem der vorherigen Ansprüche, wobei in dem Verschlussmodus die Pore (19) verschlossen wird, indem ein ausgedehnter Flächenbereich der Membran um die Pore herum mit dem Strahl abgetastet wird.

9. Verfahren nach einem der Ansprüche 1 bis 8, wobei beim Steuern des Generators eines lonenstrahls ein Bereich (20) eines Aufpralls des Strahl auf die Membran gesteuert wird.

10. Verfahren nach einem der Ansprüche 1 bis 9, wobei die Membran (4) eine Stärke von weniger als 10 Nanometern aufweist.

11. Verfahren nach einem der Ansprüche 1 bis 10, wobei die Membran (4) aus einem Material hergestellt ist, das aus der folgenden Liste ausgewählt ist: Siliziumkarbid, Siliziumoxid, Siliziumnitrid.

12. Verfahren nach einem der Ansprüche 1 bis 11, wobei der Generator eines lonenstrahls gesteuert wird, indem das Öffnen und das Schließen einer elektrostatischen Klappe steuert, die zwischen der Quelle und dem Probenhalter angeordnet ist.

13. Verfahren zum Bilden einer nanoporösen Membran nach einem der vorherigen Ansprüche, wobei ein zu erreichender Porendurchmesser (19) definiert wird und wobei der Durchdringungs- und der Verschlussmodus abwechselnd durchführt werden, bis eine Pore des genannten Durchmessers gebildet ist.

14. Verfahren zum Bilden von nanoporösen Membranen, wobei die Schritte der Verfahren nach einem der Ansprüche 1 bis 13 für eine Vielzahl von Membranen einer selben Probe, wobei die Membranen mindestens 10 Mikrometer voneinander entfernt sind, oder für eine Vielzahl von Poren in einer Membran einer Probe, wobei die Poren mindestens 0,1 Mikrometer voneinander entfernt sind, wiederholt werden.

15. Verfahren nach einem der vorherigen Ansprüche, wobei der lonenstrahl an dem Probenhalter in einem Bereich mit einstellbarem Durchmesser fokussiert wird, wobei der Durchmesser mindestens zwischen 10 Nanometern (nm) und 100 nm einstellbar ist.

16. Anlage zum Bilden einer nanoporösen Membran, umfassend:
- einen Generator (100) eines lonenstrahls unter Verwendung einer Quelle (2) von Flüssigmetallionen, wobei die Quelle angepasst ist, um einen Strahl (17) geladener Spezies entlang einer optischen Achse zu emittieren,
- einen Probenhalter (4), der angepasst ist, um eine Membran gegenüber der Quelle entlang der optischen Achse zu tragen,
- einen Detektor (15) für geladene Teilchen stromabwärts von der Membran, wobei der Teilchendetektor angepasst ist, um eine Anzahl von Ionen zu bestimmen, die durch die Membran übertragen werden, und
- eine Zentraleinheit (16), die angepasst ist, um den Generator eines lonenstrahls abhängig von der genannten Anzahl von Ionen zu steuern, indem sie mit dem Strahl auf einen Bereich zielt,
wobei die Zentraleinheit (16) angepasst ist, um Folgendes auszuwählen
. einen Durchdringungsmodus, in dem der Generator (100) eines lonenstrahls abhängig von der genannten Anzahl von Ionen gesteuert wird, um eine Pore in die Membran zu einzuprägen, und
. einen Verschlussmodus, in dem der Generator (100) eines lonenstrahls abhängig von der lonenzahl gesteuert wird, um den Generator eines lonenstrahls zu steuern, sodass er mit dem Strahl auf einen Bereich zielt, sodass die Atome der Membran, die schwach an ihre Oberfläche gebunden sind, gestreut werden und an den scharfen Kanten der Membran eine Ansammlung von Atomen erzeugt wird,
wobei der Strom und die Energie der an der Membran ankommenden Teilchen in diesen verschiedenen Modi konstant gehalten werden,
wobei die Membran eine Stärke von weniger als 100 Nanometern aufweist.

17. Anlage nach Anspruch 16, wobei der Generator (100) eines lonenstrahls eine elektrostatische Optik (3) umfasst, umfassend mindestens eines von Folgenden:
- einen Abtastgenerator (22), der angepasst ist, um den Strahl um eine Pore der Membran herum zu streuen,
- einen Löschgenerator (18), der angepasst ist, um den Strahl aus dem Probenhalter abzulenken,
- eine Linse (11, 12), die den lonenstrahl an dem Probenhalter in einem Bereich mit einstellbarem Durchmesser fokussiert, wobei der Durchmesser mindestens zwischen 10 Nanometern (nm) und 100 nm einstellbar ist.

## Claims

1. A method of forming a nano-porous membrane comprising:
- an ion beam generator (100) is provided using a liquid metal ion source (2), the source being adapted to emit a beam (17) of charged species along an optical axis (X),
- a sample holder (4) is provided carrying a membrane (5) facing the source along the optical axis,
- a charged particle detector (15) is provided downstream of the membrane, the particle detector being adapted to determine a number of ions transmitted through the membrane,
- the ion beam generator (100) is controlled in accordance with said number of ions: In a piercing mode, the ion beam generator (100) is controlled in accordance with said number of ions to etch a pore in the membrane and
- in a recapping mode, the ion beam generator (100) is controlled in accordance with said number of ions to recap a pore of the membrane, aiming at an area with the beam so as to diffuse weakly bound atoms of the membrane to its surface and create an aggregation of atoms at the sharp edges of the membrane,
the current and energy of the particles arriving at the membrane being kept constant in these different modes,
the membrane (4) having a thickness of less than 100 nanometres.

2. The method according to claim 1, wherein the charged particle detector (15) is provided downstream of the membrane along the optical axis, the particle detector being adapted to detect a number of ions transmitted through the membrane.

3. The method according to any of claims 1 to 2 wherein, when the ion beam generator is controlled, a path of said beam is controlled.

4. The method according to claim 3, wherein in the piercing mode, as long as a number of ions below a predetermined threshold is detected, the generator (100) delivers a beam of charged species to an area of the membrane.

5. The method according to claim 3 or 4, wherein, when a number of ions above a predetermined threshold is detected, the beam of charged species is diverted from the sample holder.

6. The method according to claim 3, wherein in the recapping mode, as long as a number of ions above a predetermined threshold is detected, the generator (100) delivers a beam of charged species to an expanded area of the membrane.

7. The method according to any of the preceding claims, wherein, in the recapping mode, the pore (19) is recapped by irradiating the membrane around the pore with said beam.

8. The method according to any of the preceding claims, wherein, in the recapping mode, the pore (19) is recapped by scanning an expanded surface area of the membrane around the pore with said beam.

9. The method according to any of claims 1 to 8 wherein, when the ion beam generator is controlled, an area (20) of beam impingement on the membrane is controlled.

10. The method according to any of claims 1 to 9, wherein the membrane (4) has a thickness of less than 10 nanometers.

11. The method according to any of claims 1 to 10, wherein the membrane (4) is made of a material selected from the following list: silicon carbide, silicon oxide, silicon nitride.

12. The method according to any of claims 1 to 11, wherein the ion beam generator is controlled by controlling the opening and closing of an electrostatic gate disposed between the source and the sample holder.

13. The method of forming a nano-porous membrane according to one of the preceding claims, in which a pore diameter (19) to be achieved is defined, and in which the piercing and recapping modes are alternated until a pore of said diameter is formed.

14. The method of forming nano-porous membranes, wherein the steps of the methods according to any one of claims 1 to 13 are reproduced for a plurality of membranes in a given sample, the membranes being spaced apart by at least ten microns, or for a plurality of pores in a membrane in a sample, the pores being spaced apart by at least 0.1 microns.

15. The method according to any one of the preceding claims, wherein the ion beam is focused at the sample holder into an area of adjustable diameter, the diameter being adjustable to at least between 10 nanometers (nm) and 100 nm.

16. A nanoporous membrane formation system comprising:
- an ion beam generator (100) using a liquid metal ion source (2), the source being adapted to emit a beam (17) of charged species along an optical axis (X),
- a sample holder (4) adapted to carry a membrane facing the source along the optical axis,
- a charged particle detector (15) downstream of the membrane, the particle detector being adapted to determine a number of ions transmitted through the membrane, and
- a central unit (16) adapted to control the ion beam generator in accordance with said number of ions, by targeting an area with the beam
in which the central unit (16) is adapted to select
. a piercing mode, in which the ion beam generator (100) is controlled in accordance with said number of ions to etch a pore into the membrane, and
. a recapping mode, the ion beam generator (100) is controlled in accordance with said number of ions to control the ion beam generator by aiming at an area with the beam so as to diffuse weakly bound atoms of the membrane to its surface and create an aggregation of atoms at the sharp edges of the membrane,
the current and energy of the particles arriving at the membrane being kept constant in these different modes,
the membrane having a thickness of less than 100 nanometres.

17. A system according to claim 16 wherein the ion beam generator (100) comprises an electrostatic optic (3) comprising at least one of:
- a scan generator (22) adapted to disperse the beam around a pore of the membrane,
- an erasure generator (18) adapted to divert the beam from the sample holder,
- a lens (11, 12) focusing the ion beam at the sample holder to an area of adjustable diameter, the diameter being adjustable to at least between 10 nanometres (nm) and 100 nm.
